# FASCICULE DE BREVET EUROPEEN

(11) **EP 3 399 290 B1**
(45) Date de publication et mention de la délivrance du brevet: **30.07.2025**
(21) Numéro de dépôt: 18170014.7
(22) Date de dépôt: 30.04.2018
(51) Int. Cl.: G01J 5/04, G01J 5/08, G01J 5/02

(54) **DÉTECTEUR DE RAYONNEMENT ÉLECTROMAGNÉTIQUE, ENCAPSULÉ PAR REPORT DE COUCHE MINCE**
DETEKTOR FÜR ELEKTROMAGNETISCHE STRAHLUNG, DER DURCH EINE DÜNNSCHICHT EINGEKAPSELT IST
ELECTROMAGNETIC RADIATION DETECTOR, ENCAPSULATED BY ADDING A THIN LAYER

(30) Priorité: 02.05.2017 FR 1753843
(43) Date de publication de la demande: 07.11.2018
(73) Titulaire: Commissariat à l'Energie Atomique et aux Energies Alternatives, 75015 Paris (FR)
(72) Inventeur: LEDUC, Patrick, 38000 GRENOBLE (FR); YON, Jean-Jacques, 38360 SASSENAGE (FR)
(74) Mandataire: Brevalex

(56) Documents cités:
- EP-A1- 2 172 755
- EP-A1- 2 743 659
- EP-A2- 1 243 903
- WO-A1-95/17014

## Description

### DOMAINE TECHNIQUE

L'invention concerne le domaine de l'encapsulation du ou des élément(s) sensible(s) d'un détecteur électromagnétique, pour placer ce ou ce(s) élément(s) sensible(s) à l'intérieur d'une cavité fermée.

Chaque élément sensible est ici une membrane, suspendue au-dessus d'un substrat, pour absorber un rayonnement électromagnétique et le convertir en chaleur.

La cavité fermée, de préférence sous vide, garantit une bonne isolation thermique entre la ou les membrane(s), et le substrat.

### ÉTAT DE LA TECHNIQUE ANTÉRIEURE

On connaît dans l'art antérieur différentes solutions pour encapsuler la ou les membrane(s) suspendue(s) d'un détecteur électromagnétique de type détecteur à micro-bolomètre(s).

Dans le document US 2004/0140570, il est décrit le dépôt d'un capot épais au-dessus des pixels d'un détecteur matriciel, pour fermer une cavité.

L'épaisseur du capot est de 500 µm, avec des tranchées dans lesquelles cette épaisseur est de seulement 100 µm.

Des ouvertures d'évacuation de gaz sont percées dans le capot, au niveau des tranchées.

Un tel capot présente cependant plusieurs inconvénients.

En premier lieu, du fait de son épaisseur importante, il présente une transmission réduite, puisqu'une partie du signal optique est absorbée lors de la traversée du capot. Cela impose d'utiliser des matériaux de haute qualité optique et donc relativement chers.

En second lieu, les tranchées ne doivent pas se trouver au-dessus des éléments sensibles du détecteur, pour ne pas perturber la détection.

Elles sont donc positionnées en périphérie de ces éléments sensibles, ce qui augmente l'encombrement total du détecteur avec son capot.

En outre, du fait de son épaisseur importante, le capot complique l'accès aux plots de connexion électrique, dits « plots de bonding », disposés en bordure des pixels du détecteur et assurant une connexion avec des dispositifs électroniques annexes. L'accès aux plots de connexion électrique n'est obtenu que par gravure de la totalité de l'épaisseur du capot. Outre la difficulté de réaliser cette étape de gravure, la forte épaisseur du capot impose d'éloigner les plots de bonding du bord du capot pour pouvoir réaliser l'étape de wirebonding (interconnexion), ce qui augmente l'encombrement du détecteur.

D'autres procédés de réalisation d'un capot sont connus, mettant en œuvre un dépôt de couche mince sur une couche sacrificielle entourant les membranes d'un détecteur électromagnétique de type détecteur à micro-bolomètre(s).

Un tel procédé est décrit par exemple dans la demande de brevet FR 2 966 595.

On peut ainsi obtenir un capot d'épaisseur réduite, et sans tranchée.

Un inconvénient de cette solution est cependant que l'étape de dépôt de couche mince peut impliquer des températures susceptibles de détériorer les éléments sensibles du détecteur.

D'autres exemples de l'état de la technique sont donnés dans les documents EP2743659, EP2172755, WO9517014, EP1243903 et US2004140570, ainsi que dans l'article "Study on optimizing the thickness of silicon window of WLP for IR sensor" de Myeongho Song et al., Proc. of SPIE Vol. 8353, 2012.

Un objectif de la présente invention est de proposer une solution d'encapsulation d'au moins une membrane suspendue d'un détecteur de rayonnement électromagnétique, qui ne présente pas les inconvénients de l'art antérieur.

### EXPOSÉ DE L'INVENTION

Cet objectif est atteint avec un procédé d'encapsulation d'au moins un élément sensible d'un détecteur de rayonnement électromagnétique tel que défini dans la revendication 8.

On réalise ainsi un détecteur de rayonnement électromagnétique tel que défini dans la revendication 1.

Le substrat du détecteur de rayonnement électromagnétique correspond au substrat principal, cité dans l'énoncé du procédé.

L'idée à la base de l'invention est de réaliser un capot par dépôt de couche mince, sur un substrat de report, distinct du substrat recevant la ou les membrane(s) du détecteur de rayonnement électromagnétique.

Ainsi, aucune précaution particulière n'est requise pour le dépôt de couche mince, celui-ci n'étant pas réalisé directement au-dessus de l'au moins une membrane du détecteur de rayonnement électromagnétique.

L'invention offre donc une solution d'encapsulation par un capot fin, dans laquelle la ou les membrane(s) ne sont pas soumises à des températures élevées (la température reste inférieure 400°C, voire même inférieure à 300°C, lors du procédé d'encapsulation).

La couche mince dans laquelle est réalisé le capot n'est pas manipulée seule, mais conjointement avec le substrat de report. Elle peut ainsi présenter une épaisseur réduite, inférieure ou égale à 10 µm et même encore plus préférentiellement inférieure ou égale à 5 µm. Cette faible épaisseur évite l'absorption de signal incident par le capot.

La faible épaisseur du capot facilite la réalisation d'ouvertures de petite taille pour l'évacuation des gaz, ou évents, et ne nécessite pas de tranchées.

En outre, le détecteur de rayonnement électromagnétique peut ainsi offrir un accès facile aux plots de connexion électrique, et un encombrement minimal.

Le procédé selon l'invention met en œuvre le collage d'une seconde couche de scellement sur une première couche de scellement, pour solidariser la couche mince formée sur le substrat de report, du restant du détecteur de rayonnement électromagnétique. Ces deux couches de scellement, superposées et collées l'une sur l'autre, sont donc caractéristiques de l'invention.

Le détecteur selon l'invention peut, en outre, présenter l'une ou plusieurs des caractéristiques ci-dessous.

Le capot peut être suspendu en appui sur des piliers de soutien situés entre les parois de soutien, le détecteur comprenant alors des paires de premier et second plots de scellement, métalliques, chaque paire étant située entre le capot et l'un des piliers de soutien, les premier et second plots de scellement de chaque paire étant superposés et séparés par une zone interne de collage respective.

Le détecteur peut présenter une pluralité de membranes suspendues au-dessus du substrat, un pas de répartition des membranes étant égal à un pas de répartition des piliers de soutien, dans chaque dimension du plan du substrat.

La ou les membrane(s) peuvent être suspendue(s) au-dessus du substrat, en appui chacune sur des piliers d'appui, et pour chaque membrane, l'un des piliers d'appui est surmonté par une paire de premier et second plots de scellement, de sorte que ledit pilier d'appui forme également un pilier de soutien pour le capot.

La ou les membrane(s) peuvent être suspendue(s) au-dessus du substrat, en appui chacune sur des piliers d'appui, et pour chaque membrane, l'un des piliers d'appui est surmonté d'une ouverture traversante du capot.

Une épaisseur cumulée des première et des seconde couches de scellement peut être comprise entre 1,5 µm et 2,5 µm.

De la même façon, le procédé selon l'invention peut, en outre, présenter l'une ou plusieurs des caractéristiques ci-dessous.

L'empilement capteur peut comporter en outre des piliers de soutien, s'étendant entre les parois de soutien, et surmontés chacun par un premier plot de scellement respectif, l'étape c) comprenant également la réalisation, sur la couche de capot, de seconds plots de scellement, et l'étape d) réalisant également l'alignement et le collage deux à deux, des premiers plots de scellement avec les seconds plots de scellement.

L'étape de gravure de la couche de capot peut être mise en œuvre après l'étape e) de retrait du substrat de report.

L'étape de gravure de la couche de capot peut être mise en œuvre après l'étape b) de dépôt de la couche de capot et avant l'étape d) de report du substrat de report, l'étape de gravure de la couche de capot étant suivie d'une étape de remplissage des régions gravées par une couche en matériau sacrificiel, dite couche sacrificielle de capot, et la couche sacrificielle de capot étant évacuée après l'étape e) de retrait du substrat de report.

Le procédé peut comprendre des étapes de dépôt de couches en matériau sacrificiel, dites couches sacrificielles d'arrêt, de sorte qu'avant l'étape d) de report du substrat de report, la première couche de scellement et la deuxième couche de scellement soient situées chacune dans l'une de ces couches sacrificielles d'arrêt, l'étape d) mettant en œuvre un collage hybride, et les couches sacrificielles d'arrêt étant évacuées après l'étape e) de retrait du substrat de report.

Dans l'empilement capteur, à l'issue de l'étape a), l'au moins une membrane peut s'étendre au-dessus d'une couche en matériau sacrificiel, dite couche sacrificielle de membrane, la couche sacrificielle de membrane étant évacuée après l'étape e) de retrait du substrat de report.

Le procédé peut être mis en œuvre simultanément pour plusieurs empilements capteur partageant le même substrat principal, et à l'aide d'un unique substrat de report et d'une unique couche de capot, une étape de gravure de la couche de capot délimitant les contours externes de plusieurs capots destinés chacun à recouvrir l'un parmi les plusieurs empilements capteur.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- la figure 1A illustre de manière schématique, selon une vue en coupe, un détail d'un premier mode de réalisation d'un détecteur de rayonnement électromagnétique selon l'invention ;
- la figure 1B illustre de manière schématique et selon une vue de dessus, le détecteur de la figure 1A ;
- les figures 2A à 2C illustrent de manière schématique un pixel d'un deuxième mode de réalisation d'un détecteur selon l'invention, dans lequel un évent de libération de couche sacrificielle et un pilier de soutien du capot sont placés de manière particulièrement astucieuse ;
- les figures 3A et 3B illustrent les étapes d'un procédé selon l'invention, pour fabriquer un détecteur de rayonnement électromagnétique selon l'invention ;
- les figures 4 et 5 illustrent deux variantes du procédé illustré aux figures 3A et 3B ; et
- les figures 6A et 6B illustrent la mise en œuvre d'un procédé selon l'invention, pour fabriquer simultanément plusieurs détecteurs selon l'invention.

### EXPOSÉ DÉTAILLÉ DE MODES DE RÉALISATION PARTICULIERS

Dans la description qui suit, les termes « sur », « au-dessus », « supérieur », « sous », « dessous », « inférieur », se rapportent à l'orientation des figures correspondantes.

Pour plus de clarté, on a représenté sur certaines des figures les axes (Ox), (Oy) et/ou (Oz) d'un repère orthonormé.

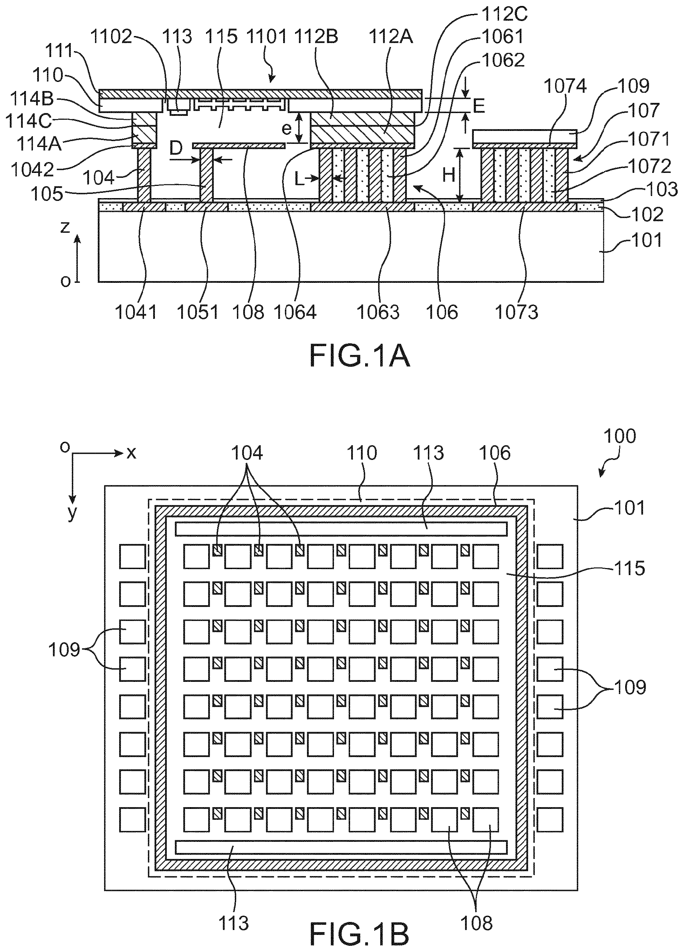

La figure 1A illustre de manière schématique, et selon un vue en coupe, un détail d'un détecteur de rayonnement électromagnétique selon un premier mode de réalisation de l'invention.

La figure 1B illustre ce détecteur de manière schématique, et selon une vue de dessus.

Le détecteur de rayonnement électromagnétique 100 est un détecteur infrarouge, ou téra-Hertz, fonctionnant à température ambiante.

Il comprend un substrat 101, par exemple en silicium, dans lequel sont intégrés des circuits de lecture réalisés par exemple en technologie CMOS.

Le substrat 101 est recouvert ici d'une couche intermédiaire 102, optionnelle, constituée d'un matériau électriquement isolant.

La couche intermédiaire 102 est recouverte ici d'une fine couche de protection 103, optionnelle, qui protège les circuits de lecture lors d'une étape de libération de la membrane, si nécessaire.

Le détecteur 100 comprend également une matrice de membranes 108, suspendues chacune au-dessus du substrat 101.

Les membranes 108 sont réparties ici en lignes et colonnes au-dessus du substrat.

Elles définissent chacune un pixel du détecteur 100.

Chaque membrane 108, ou planche suspendue, est constituée d'un matériau présentant une forte absorption dans l'infrarouge (longueurs d'onde comprises entre 0,8 µm et 100 µm) et/ou le térahertz (longueurs d'onde comprises entre 100 µm et 5 mm).

Chaque membrane est associée à un élément thermométrique (non représenté), pour mesurer sa température.

Les éléments thermométriques des membranes 108 sont connectés électriquement aux circuits de lecture du substrat 101.

Chaque élément thermométrique peut être formé par un élément thermo-résistif, accolé à la membrane, et dont la résistance électrique est fonction de la température.

L'élément thermométrique définit alors, avec la membrane, la planche bolométrique d'un micro-bolomètre.

En variante, chaque élément thermométrique peut être formé par un transistor ou une diode accolé à la membrane, un courant dans ce transistor ou cette diode étant fonction de la température. Le cas échéant, la membrane peut former l'un des éléments du transistor (ou de la diode).

L'élément thermométrique définit alors, avec la membrane, la planche suspendue d'un capteur semblable à un micro-bolomètre, excepté que la température de la membrane se traduit par une variation d'un courant dans un transistor ou dans une diode, et non une variation de la résistance d'un élément thermo-résistif.

Dans la suite, on utilise l'expression « capteur de type micro-bolomètre », pour désigner l'une ou l'autre de ces variantes.

On ne décrira pas ici plus en détail les capteurs de type micro-bolomètre, ces derniers étant bien connus de l'homme du métier.

Des structures verticales s'étendent dans un étage situé entre les membranes 108 et le substrat 101. Les structures sont dites verticales, car elles s'étendent chacune selon l'axe (Oz), orthogonales au plan du substrat 101. Elles comprennent :
- des parois de soutien 106, pour supporter un capot tel que décrit dans la suite ;
- des piliers de soutien 104, également pour supporter le capot ;
- des piliers d'appui 105, pour supporter des membranes 108 telles que décrites dans la suite, et servant aussi à connecter électriquement chaque membrane avec les circuits de lecture du substrat ; et
- des blocs de surélévation 107, sur lesquels sont formés des plots de connexion électrique.

Ici, les différentes structures verticales présentent toutes la même hauteur H selon l'axe vertical (Oz), et sont constituées d'un même matériau ou d'un même ensemble de matériaux.

Elles sont constituées par exemple en silicium, notamment un silicium amorphe ou un poly silicium, ou d'un empilement de couches métalliques (nitrure de titane et cuivre, ou nitrure de titane et tungstène, ...).

Les piliers d'appui 105 présentent chacun un diamètre D de l'ordre du micromètre, compris par exemple entre 0,4 µm et 1,5 µm, en particulier 1 µm.

Ils présentent chacun une base horizontale 1051 qui s'étend dans un plan parallèle au substrat, en traversant la couche 102 électriquement isolante.

Chaque membrane est en appui sur au moins deux piliers d'appui 105.

Les parois de soutien 106 entourent la matrice de membranes 108.

Elles comprennent ici quatre parois verticales, délimitant au-dessus du substrat 101 une surface carrée ou rectangulaire. Pour éviter les contraintes mécaniques dans les angles à 90°, le nombre de parois peut être augmenté de façon à augmenter un nombre d'angles saillants entre les parois (angles supérieurs à 90°). Les parois de soutien délimitent alors une surface en forme de polygone.

Les parois de soutien 106 comprennent ici plusieurs parois élémentaires de soutien 1061.

Les parois élémentaires de soutien 1061 délimitent des surfaces imbriquées les unes dans les autres et concentriques.

Les parois élémentaires 1061 dites internes, disposées à l'intérieur de la structure formant les parois de soutien 106, peuvent délimiter une surface de manière discontinue. Au contraire, les parois élémentaires externes délimitent une surface préférentiellement de manière continue.

Les parois élémentaires 1061 sont espacées les unes des autres, et présentent chacune une largeur L, par exemple égale au diamètre D.

Les espaces entre deux parois élémentaires 1061 voisines sont remplis par un matériau dit sacrificiel 1062, qui n'aura pas été évacué à l'issue des étapes de fabrication du détecteur 100 selon l'invention.

En variante, les parois de soutien ne sont pas constituées de parois élémentaires entre lesquelles se trouve un matériau sacrificiel, mais de parois larges.

Les parois de soutien 106 présentent également une base horizontale 1063 et un plateau supérieur 1064, qui s'étendent chacun dans un plan parallèle au substrat.

Les piliers de soutien 104 présentent par exemple la même section que les piliers d'appui 105, ou une section plus réduite.

Ici, ils présentent chacun une base horizontale 1041, et un plateau supérieur 1042, s'étendant chacun d'un seul tenant dans un plan parallèle au substrat.

Les piliers de soutien 104 s'étendent à l'intérieur du volume délimité par les parois de soutien 106.

Ils s'étendent ici entre les membranes 108, selon le même pas de répartition P que les membranes, dans chacune des dimensions du plan du substrat. Ce pas est par exemple compris entre 5 µm et 17 µm, par exemple 10 µm.

Selon chacune des dimensions du plan du substrat, il y a Nx et Ny membranes, et Mx et My piliers de soutien, avec par exemple Mx=Nx et My=Ny (un pilier de soutien par pixel), ou Mx=Nx-1 et My=Ny-1.

Le pas de répartition des piliers de soutien 104 peut également être un multiple du pas P des membranes, respectivement n(x)*P et n(y)*P selon les directions x et y, n(x) et n(y) étant des nombres entiers. Selon chacune des dimensions du plan du substrat, il y a alors Nx et Ny membranes, et Mx et My piliers de soutien, avec par exemple Mx=Nx/n(x) et My=Ny/n(y) (selon chaque dimension x et y, un pilier de soutien par n(x), respectivement n(y) pixels) ou Mx=[Nx/n(x)]-1 et My=[Ny/n(y)]-1.

Les piliers de soutien 104 et les parois de soutien 106 participent ensemble à supporter un capot 110.

Les piliers de soutien 104 ne sont pas forcément nécessaires pour des détecteurs présentant un nombre réduit de pixels (c'est-à-dire ici un nombre réduit de membranes).

Les blocs de surélévation 107 comprennent ici plusieurs parois ou piliers élémentaires 1071, présentant par exemple chacun une largeur, respectivement un diamètre, égal(e) au diamètre D.

Les espaces entre deux parois ou piliers élémentaires 1071 sont remplis par un matériau dit sacrificiel 1072, qui n'aura pas été évacué à l'issue des étapes de fabrication du détecteur 100 selon l'invention.

En variante, les blocs de surélévation ne sont pas formés de parois ou piliers élémentaires séparés par un matériau sacrificiel, mais par un pilier large, de diamètre supérieur à D.

Ici, les blocs de surélévation 107 présentent chacun une base horizontale 1073, et un plateau supérieur 1074, s'étendant chacun dans un plan parallèle au substrat.

Les blocs de surélévation 107 sont surmontés chacun par un plot de connexion électrique 109, connecté électriquement à des circuits de lecture intégrés dans le substrat 101.

Les plots de connexion électrique 109, ou plots de bonding, fournissent des points de connexion électrique aux circuits de lecture intégrés dans le substrat 101, pour des circuits électroniques annexes.

Ici, chaque plot de connexion électrique 109 s'étend en contact physique direct avec le plateau supérieur 1074 d'un bloc de surélévation 107.

Les plots de connexion électrique sont par exemple en aluminium.

Comme illustré en figure 1B, les plots de connexion électrique s'étendent par exemple selon deux colonnes parallèles, situées de part et d'autre de la matrice de membranes, à l'extérieur du volume délimité par les parois de soutien 106. Les plots de connexion électrique peuvent également être présents sur les quatre côtés de la matrice.

Le capot 110 s'étend dans un plan parallèle au substrat 101, et présente une épaisseur E constante comprise entre 0,5 µm et 10 µm bornes incluses, de préférence entre 0,5 µm et 5 µm bornes incluses, par exemple 2 µm.

Le capot 110 est transparent aux longueurs d'onde détectées par les capteurs de type bolométriques du détecteur 100. Il présente par exemple un coefficient de transmission supérieur ou égal à 70% à au moins une longueur d'onde détectée par le détecteur 100.

Grâce à sa faible épaisseur, le capot peut remplir cette condition de transparence, tout en étant constitué d'un matériau présentant des propriétés de transmission médiocres. Il peut par exemple être constitué d'un matériau autre qu'un silicium haute qualité. L'invention offre donc une grande liberté de choix de matériau pour le capot, d'autant que ce dernier est déposé sans contrainte de température ni de conformité (voir plus loin).

Le capot 110 est constitué par exemple de silicium ou de germanium.

Il s'étend au-dessus des membranes, sans dépasser jusqu'au-dessus des plots de connexion 109. Il peut cependant dépasser légèrement relativement aux parois de soutien 106. Les contours externes du capot 110 sont représentés en traits pointillés sur la figure 1B.

Le capot peut présenter des régions texturées 1101 situées au regard des membranes 108, réalisées par exemple par lithographie. Ces textures servent à filtrer le rayonnement incident ou servent d'antireflet pour le rayonnement de façon à améliorer la transmission optique vers la membrane 108.

Le capot 110 présente également des ouvertures traversantes 1102, ou évents, ou trous.

Chaque ouverture traversante 1102 est par exemple de forme rectangulaire ou oblongue, où la petite dimension est inférieure à 0,8 µm, par exemple environ 0,5 µm. Il est aussi possible de prévoir, tel que décrit ci-après, des ouvertures traversantes circulaires dont le diamètre est inférieur à 0,8µm, par exemple 0,5µm.

Elles sont réparties régulièrement au-dessus du substrat, de préférence selon un motif présentant le même pas de répartition P que les membranes, dans chacune des dimensions du plan du substrat.

De préférence, chaque pixel du détecteur 100 comprend au moins une ouverture traversante 1102.

Les ouvertures traversantes 1102 permettent notamment d'évacuer un matériau sacrificiel utilisé pour la fabrication du détecteur 100.

Elles sont ensuite rebouchées, ici par une couche de bouchage 111, transparente, recouvrant le capot (sans recouvrir les plots de connexion). La couche de bouchage 111 participe alors à l'herméticité de la cavité hermétique 115.

La couche de bouchage 111 peut présenter également une fonction optique, par exemple une fonction anti-reflet ou de filtrage spectral.

Selon des variantes non représentées, des couches minces, distinctes de la couche de bouchage 111, peuvent s'étendre au-dessus du capot 110, par exemple une couche de traitement antireflet, et/ou un filtre spectral.

Les ouvertures traversantes 1102 s'étendent de préférence au regard de régions situées entre les membranes 108.

Ce positionnement évite toute dégradation des membranes lors d'une étape de rebouchage des ouvertures traversantes 1102, une partie du matériau de rebouchage pouvant tomber sur les membranes si ces dernières se trouvent au regard des ouvertures traversantes.

Ce positionnement implique un écartement entre les membranes 108, au moins égal au diamètre d'une ouverture traversante 1102.

Or, le diamètre d'une ouverture traversante 1102 peut être très faible, par exemple 0,5 µm, grâce à l'épaisseur réduite du capot 110. Le diamètre minimal d'une ouverture traversante est en effet fonction de l'épaisseur du capot, le rapport de l'épaisseur divisée par ledit diamètre minimal étant environ égal à 10.

On peut ainsi obtenir un fort taux d'occupation surfacique par les membranes 108, tout en ayant un faible pas de répartition des membranes, et des ouvertures traversantes 1102 au regard des espaces entre les membranes.

Le faible diamètre d'une ouverture traversante permet également d'éviter toute perturbation optique d'un rayonnement électromagnétique à détecter, le diamètre de celle-ci restant faible comparé aux longueurs d'onde détectées par le détecteur 100.

Le détecteur 100 comprend en outre une première couche de scellement 112A et une deuxième couche de scellement 112B.

Les deux couches de scellement 112A, 112B sont en métal, superposées et collées l'une sur l'autre.

Par « collées », on entend fixées l'une sur l'autre, par exemple par collage hybride ou par collage impliquant une fusion de matériau.

Ce collage se traduit par une zone de collage 112C, dite périphérique, entre ces deux couches.

Les deux couches de scellement 112A, 112B s'étendent entre la paroi de soutien 106 et le capot 110.

En particulier, la première couche de scellement 112A s'étend en contact physique direct avec une face supérieure de la paroi de soutien 106, ici une face supérieure du plateau supérieur 1064, du côté opposé au substrat 101.

La première couche de scellement 112A s'étend selon un chemin en boucle fermée, et délimite au-dessus du substrat 101 la même surface que celle délimitée par les parois de soutien 106.

La seconde couche de scellement 112B s'étend ici en contact physique direct avec une face inférieure du capot 110.

Elle n'est séparée de la première couche de scellement 112A que par la zone de collage périphérique 112C.

La zone de collage périphérique 112C est constituée par exemple d'une fine couche métallique, d'un métal différent de celui des première et seconde couches de scellement, ou d'une fine couche du métal desdites couches de scellement ayant fondu lors d'une étape de collage. Le cas échéant, les deux couches de scellement peuvent être en contact physique direct l'une avec l'autre, la zone de collage périphérique correspondant simplement à une interface entre ces deux couches, collées l'une sur l'autre sans couche intermédiaire de collage.

La seconde couche de scellement 112B est superposée à la première couche de scellement 112A, et s'étend selon le même chemin. Elle s'étend donc selon un chemin en boucle fermée, et délimite au-dessus du substrat 101 la même surface que celle délimitée par les parois de soutien 106.

Les première et seconde couches de scellement 112A, 112B forment ensemble un cordon périphérique, autour des membranes 108.

Elles sont en métal, composées d'un seul métal ou d'un alliage métallique, ou composés d'un empilement de métaux ou alliages métalliques. Elles comprennent un ou plusieurs métaux tels que par exemple le cuivre, le nitrure de titane, le nitrure de tantale, le nickel, l'or, l'indium, l'étain ou un alliage à base d'étain tel que le CuSn ou l'AuSn. De préférence, elles sont toutes deux en cuivre.

L'épaisseur cumulée des deux couches de scellement 112A, 112B est de l'ordre de 2 µm.

Cette épaisseur correspond ici à la distance entre les membranes 108 et le capot 110, notée « e » sur la figure 1A.

De la même manière, le détecteur comporte des paires de premier et second plots de scellement 114A, 114B.

Chaque paire s'étend entre le capot et un pilier de soutien 104, tous les piliers de soutien 104 étant surmontés par l'une de ces paires.

Comme précisé à propos des piliers de soutien 104, ces plots de scellement ne sont pas forcément nécessaires, pour des détecteurs présentant un nombre réduit de pixels.

Dans chaque paire, les premier et second plots de scellement 114A, 114B sont superposés, et fixés l'un à l'autre par collage.

Ils présentent la même composition, métallique, que les deux couches de scellement.

Ils présentent également la même épaisseur cumulée que les deux couches de scellement.

Les premier et second plots de scellement 114A, 114B présentent chacun une section de diamètre sensiblement égal à celui d'un pilier de soutien, par exemple 1 µm, et en tout état de cause moins de 3 µm.

Chaque premier plot de scellement 114A s'étend en contact physique direct avec un pilier de soutien 104, en particulier une face supérieure du plateau supérieur 1041 de ce pilier de soutien.

Chaque second plot de scellement 114B s'étend en contact physique direct avec le capot 110.

Chaque second plot de scellement 114B est séparé du premier plot de scellement correspondant par une zone de collage interne 114C, de même nature que la zone de collage périphérique 112C.

Le capot est supporté en appui sur les première et seconde couches de scellement 112A, 112B, situées elles-mêmes sur les parois de soutien, et sur les premier et second plots de scellement 114A, 114B, situés eux-mêmes sur les piliers de soutien.

Les première et seconde couches de scellement 112A, 112B définissent, avec les parois de soutien 106, les parois latérales d'une cavité hermétique 115 recevant les membranes 108.

Du côté opposé au substrat, cette cavité hermétique 115 est fermée par le capot 110.

Les première et seconde couches de scellement 112A, 112B, participent à l'herméticité de la cavité 115, en plus de leur fonction de support mécanique.

Le vide est fait dans la cavité hermétique 115 par les ouvertures traversantes 1102, avant leur bouchage par la couche 111.

L'épaisseur cumulée des première et seconde couches de scellement, telle que mentionnée ci-avant, est suffisamment élevée pour que l'élimination par gravure des matériaux entre la membrane et le capot ne pose pas de difficultés.

On remarque ici que cette épaisseur est également suffisamment fine pour que la réalisation des première et seconde couches de scellement, et des premier et second plots de scellement, ne pose pas de difficulté technologique. Cette épaisseur permet par exemple l'utilisation de procédés de Polissage Mécano-Chimique (CMP).

Ici, un matériau getter 113 est disposé contre le capot 110, à l'intérieur de la cavité 115, pour maintenir la qualité du vide au cours du temps dans la cavité 115.

Un matériau getter, ou piège à gaz, limite l'apparition de gaz dans une enceinte. Il peut s'agir d'un métal facilement oxydable tel que du titane, ou du vanadium, du zirconium, du cobalt, du fer, du manganèse, de l'aluminium ou un alliage de ces métaux.

Le matériau getter 113 s'étend dans la cavité 115.

Il forme par exemple deux barres parallèles entre elles, s'étendant le long de deux bords opposés de la matrice de membranes, les plots de connexion 109 s'étendant le long des deux autres bords de la matrice de membranes. Cet exemple n'est pas limitatif. Le matériau getter peut également, par exemple, être positionné du côté du substrat.

Par simple souci d'illustration, le matériau getter n'est pas positionné de la même façon en figure 1A, afin de pouvoir l'illustrer en même temps que les plots de connexion 109.

Le détecteur 100 est adapté à détecter un rayonnement électromagnétique se propageant orthogonal au plan du substrat 101, et incident sur les membranes depuis le côté opposé au substrat 101.

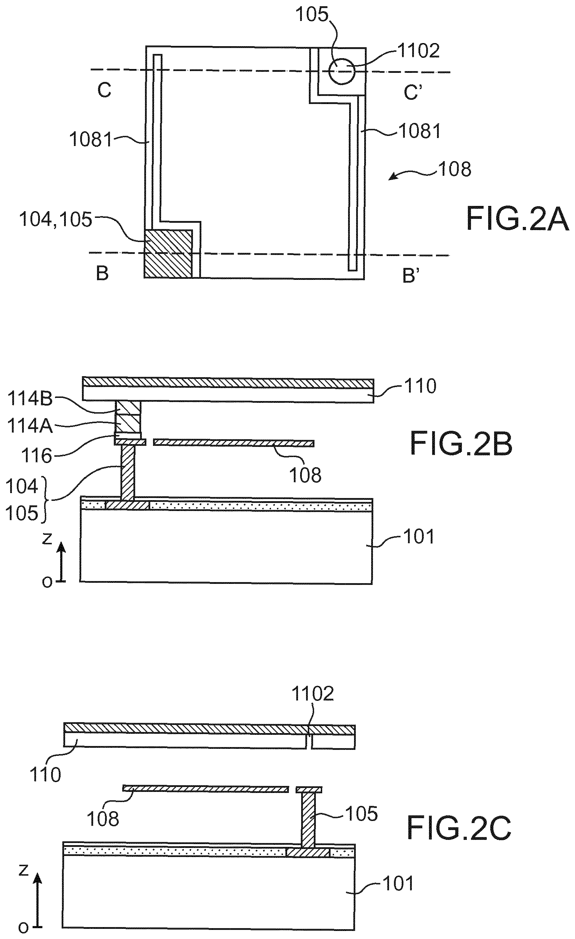

Les figures 2A à 2C illustrent un deuxième mode de réalisation d'un détecteur selon l'invention.

La figure 2A représente de manière schématique un pixel d'un tel détecteur, selon une vue de dessus.

Chaque pixel reçoit une unique membrane 108, en appui sur deux piliers d'appui 105.

La figure 2B représente une vue en coupe simplifiée de ce pixel, dans un plan vertical BB' passant un premier pilier d'appui 105.

La figure 2C représente une vue en coupe simplifiée de ce pixel, dans un plan vertical CC' parallèle au plan BB' et passant par l'autre pilier d'appui 105.

Selon ce deuxième mode de réalisation, dans chaque pixel, l'un des piliers d'appui 105 de la membrane forme également un pilier de soutien 104, pour supporter le capot 110.

En pratique, l'un des piliers d'appui 105 est simplement surmonté par un premier et un second plots de scellement 114A, 114B tels que décrits ci-avant.

De préférence, tous les piliers de soutien sous le capot forment également un pilier d'appui pour une membrane.

Ainsi, un taux de remplissage surfacique par les membranes 108 n'est pas limité par l'encombrement de piliers de soutien 104 distincts des piliers d'appui des membranes.

Selon ce mode de réalisation, une isolation électrique est nécessaire, pour éviter de relier électriquement les membranes 108, par l'intermédiaire du capot 110 et des paires de premier et second plots de scellement 114A, 114B.

Un plot 116 d'isolation électrique s'étend donc au regard de chaque paire de premier et second plots de scellement 114A, 114B.

Ici, un plot d'isolation 116 respectif s'étend sous chaque paire de premier et second plots de scellement 114A, 114B. Le plot d'isolation 116 s'étend ici entre le pilier de soutien 104 (également pilier d'appui) et le premier plot de scellement. Selon une variante non représentée, le plot d'isolation 116 s'étend entre le capot 110 et le second plot de scellement 114B.

Le plot d'isolation 116 est par exemple en matériau diélectrique, par exemple le SiC, SiCN, SiOC, Al₂O₃, AIN, etc. Il s'agit de préférence d'un matériau résistant à une gravure mise en œuvre pour l'évacuation d'une couche sacrificielle, lors de la fabrication du détecteur, en particulier un matériau résistant à la gravure par vapeur d'acide fluorhydrique (HF).

Selon le second mode de réalisation illustré aux figures 2A à 2C, chaque pixel comporte un unique évent 1102, situé au-dessus de l'autre des piliers d'appui 105 supportant la membrane 108.

L'évent, ou ouverture traversante 1102, ne dépasse pas latéralement relativement au pilier de soutien, ce qui est possible grâce au faible diamètre de l'évent, lui-même rendu possible par la faible épaisseur du capot.

En particulier, le diamètre du pilier d'appui 105 est de l'ordre de 1 µm. Le diamètre de l'évent est de l'ordre de 0,5 µm, et une précision d'alignement de l'un relativement à l'autre peut être inférieure à 0,2 µm.

La membrane 108 est suspendue en appui sur les piliers d'appui 105, par l'intermédiaire de bras 1081, qui s'étendent latéralement, parallèles au plan du substrat 101. Par conséquent, chaque ouverture traversante 1102 ainsi positionnée ne s'étend pas au regard d'une membrane.

Ce positionnement des ouvertures traversantes 1102 permet que le taux de remplissage surfacique par les membranes 108 ne soit pas limité par la présence des ouvertures traversantes 1102.

Selon des variantes non représentées, le détecteur peut ne présenter que la caractéristique relative au positionnement des ouvertures traversantes, ou que la caractéristique relative aux piliers de soutien.

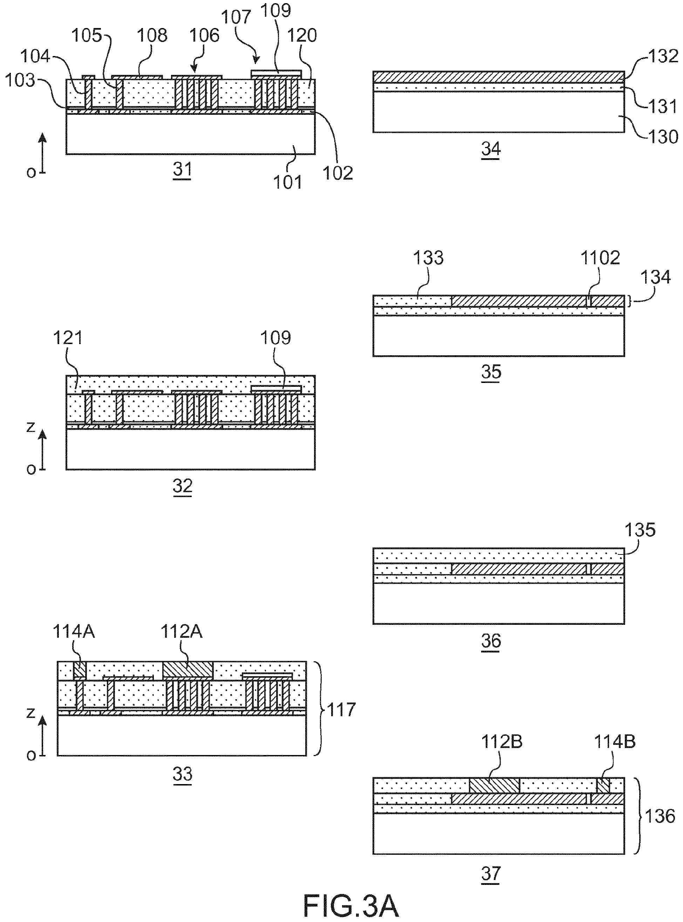

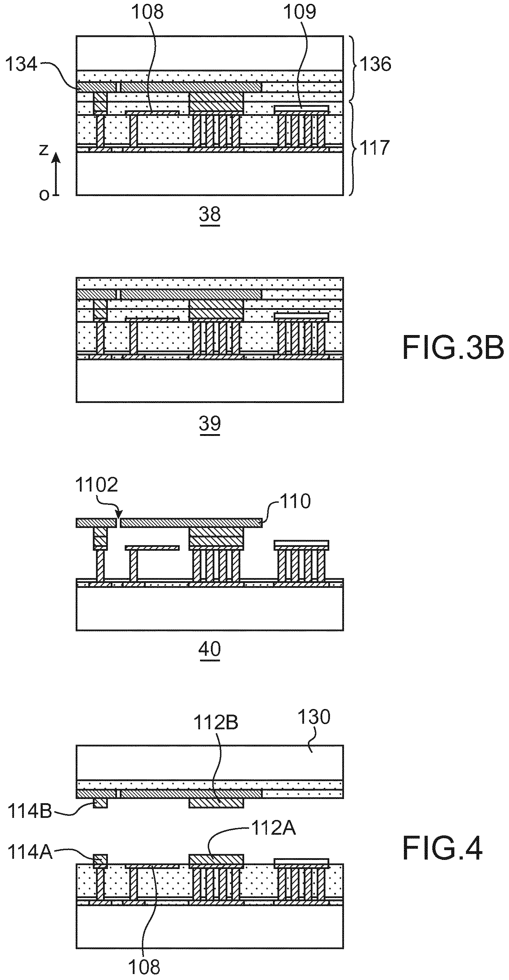

Les figures 3A et 3B illustrent les étapes d'un procédé de fabrication d'un détecteur selon l'invention.

On a représenté sur la gauche, des étapes mises en œuvre au-dessus d'un premier substrat, dit substrat principal 101, correspondant au substrat tel que décrit en référence à la figure 1.

Dans une première étape 31, on réalise un empilement, comportant superposés :
- le substrat principal 101, comportant des circuits de lecture ;
- la couche intermédiaire 102, telle que décrite en référence à la figure 1A ;
- la couche de protection 103, telle que décrite en référence à la figure 1A ;
- les différentes structures verticales telles que décrites en référence à la figure 1A (piliers d'appui 105, piliers de soutien 104, parois de soutien 106, et blocs de surélévation 107), formées dans une couche sacrificielle 120 dite couche sacrificielle de membrane ; et
- les membranes 108 et les plots de connexion 109 tels que décrits en référence à la figure 1A.

Les structures verticales sont formées par gravure de tranchées dans la couche sacrificielle 120, et dépôt de matériau pour remplir les tranchées.

Les parois de soutien 106 et les blocs de surélévation peuvent être formés chacun par gravure de plusieurs tranchées dans la couche sacrificielle 120, pour obtenir *in fine* des structures telles que décrites en référence à la figure 1A. On peut ainsi réaliser des structures plus larges que les piliers de soutien et piliers d'appui, à l'aide de la même étape de gravure que pour lesdits piliers.

La couche sacrificielle 120 s'étend jusqu'à hauteur des faces inférieures des membranes 108, du côté opposé au substrat principal 101.

Les membranes 108 sont réalisées par lithographie et gravure, au-dessus de la couche sacrificielle 120.

La réalisation de l'empilement ne sera pas décrite ici plus avant, puisqu'elle correspond à des étapes connues de fabrication d'un détecteur de type bolométrique, excepté que l'on réalise d'autres structures verticales en plus des piliers d'appui pour les membranes.

Ensuite, on dépose une nouvelle couche sacrificielle, dite première couche sacrificielle d'arrêt 121, recouvrant les membranes 108 et les plots de connexion 109 (étape 32).

Puis, dans une étape 33, la première couche sacrificielle d'arrêt 121 est gravée au-dessus des piliers de soutien 104 et des parois de soutien 106, et les ouvertures gravées sont remplies de métal pour former les premiers plots de scellement 114A, et la première couche de scellement 112A.

Le procédé de réalisation des premiers plots de scellement et de la première couche de scellement 112A, 114A met en œuvre des procédés dits damascènes, avec dépôt de métal puis planarisation pour obtenir des plots et couche affleurant à la surface de la première couche sacrificielle d'arrêt 121, du côté opposé au substrat 101.

L'empilement obtenu à l'issue de l'étape 33 est dit empilement capteur 117.

Indépendamment des étapes 31 à 33, on met en œuvre une deuxième série d'étapes, impliquant un second substrat, dit substrat de report 130.

Le substrat de report 130 est par exemple en silicium, ou en verre, et ne comporte aucun circuit intégré.

A l'étape 34, on dépose une couche sacrificielle intermédiaire 131 sur le substrat 130, puis une couche dite de capot 132 sur la couche sacrificielle intermédiaire 131.

Le matériau et l'épaisseur de la couche de capot correspondent au matériau et à l'épaisseur du capot décrite en référence à la figure 1A.

En variante, les couches 130, 131 et 132 peuvent être issues d'un substrat SOI (silicium sur isolant) ou GOI (germanium sur isolant).

A l'étape 35, la couche de capot 132 est gravée, puis une nouvelle couche sacrificielle 133, dite couche sacrificielle de capot, est déposée pour remplir les ouvertures gravées dans la couche de capot 132.

La couche de capot 132 est gravée alors qu'elle s'étend au-dessus de la couche sacrificielle de capot, et non au-dessus des membranes 108. On évite ainsi la chute de résidus de gravure sur les membranes 108 et sur les plots de connexion 109.

La gravure consiste à délimiter les contours externes du capot tel que décrit en référence à la figure 1A, et à former les ouvertures traversantes 1102 du capot.

On délimite en particulier un capot configuré pour ne pas recouvrir les plots de connexion 109, à l'issue des étapes de fabrication du détecteur selon l'invention.

La couche sacrificielle de capot 133 et la couche de capot gravée forment ensemble une surface plane, du côté opposé au substrat de report 130.

A l'issue de l'étape 35, on a donc réalisé, au-dessus du substrat de report 130, une couche 134 comportant des régions en matériau sacrificiel et des régions de capot transparentes à des longueurs d'onde à détecter.

Les régions en matériau sacrificiel sont destinées à former des ouvertures traversantes dans le capot, respectivement des régions d'accès aux plots de connexion 109.

Dans une étape 36, on dépose au-dessus de la couche 134 une seconde couche sacrificielle d'arrêt 135.

Dans une étape 37, la seconde couche sacrificielle d'arrêt 135 est gravée aux emplacements de la seconde couche de scellement et des seconds plots de scellement tels que décrits en référence à la figure 1A, puis les ouvertures gravées sont remplies de métal pour former lesdits plots et couche 114B, 112B.

Là-encore, des procédés damascènes connus de l'homme du métier sont mis en œuvre, pour obtenir des plots et couche affleurant à la surface de la seconde couche sacrificielle d'arrêt 135, du côté opposé au substrat de report 130.

Les ouvertures gravées sont positionnées de façon à se retrouver au-dessus de la première couche de scellement, respectivement des premiers plots de scellement, lorsque le substrat de report est retourné et placé au-dessus du substrat principal 101.

On obtient à l'issue de l'étape 37 un empilement dit empilement de report 136.

Les étapes 31 à 33 d'une part, et 34 à 37 d'autre part, peuvent être mises en œuvre en parallèle, ou les unes après les autres, d'abord les étapes 31 à 33 ou d'abord les étapes 34 à 37.

Les différentes couches sacrificielles sont de préférence en matériau diélectrique, en particulier en dioxyde de silicium SiO₂.

Les deux couches sacrificielles d'arrêt définissent la hauteur des couches et plots de scellement 114A, 112A, 114B, 112B. Elles servent également de couche d'arrêt pour les procédés damascènes, et participent à la définition d'un support mécanique plan pour le report ultérieur du capot.

La figure 3B illustre les étapes ultérieures du procédé.

A l'étape 38, on retourne l'empilement de report 136 et on le dépose sur l'empilement capteur 117, de sorte que les première et seconde couches de scellement 112A, 112B, et les premiers et seconds plots de scellement 114A, 114B, soient alignés deux à deux, et en contact physique direct deux à deux.

La couche 134 telle que décrite ci-avant s'étend au-dessus de l'empilement capteur 117 de sorte que les régions de capot s'étendent au-dessus des membranes 108, et les régions en matériau sacrificiel s'étendent au-dessus des plots de connexion 109 ainsi qu'aux emplacements des futures ouvertures traversantes dans le capot.

La précision d'alignement est de l'ordre de 0,2 µm.

L'empilement capteur 117 et l'empilement de report 136 sont fixés ensemble par un collage sans couche intermédiaire adhésive, dit collage hybride, ou en anglais « hybrid bonding ».

La fixation met en œuvre des forces attractives telles que les forces de Van der Waals et les liaisons hydrogène.

La fixation n'implique pas nécessairement un chauffage à haute température. En particulier, la température reste strictement inférieure à 300°C.

Ce collage est dit « hybride », car il implique à la fois le matériau des première et seconde couches sacrificielles d'arrêt, et le matériau des couches et plots de scellement 112A, 112B, 114A ; 114B.

Le collage hybride cuivre sur cuivre et dioxyde de silicium sur dioxyde de silicium est connu de l'homme du métier, et ne sera pas décrit plus amplement dans la suite.

Si besoin, l'homme du métier pourra se reporter par exemple à l'article suivant : « Advance Toward Reliable High Density Cu-Cu Interconnects by Cu-SiO2 Direct Hybrid Bonding », Y Beilliard & al., publié dans 3D Systems Integration Conference (3DIC), 2014 International, IEEE.

Dans une étape 39, on retire le substrat de report 130, par exemple par polissage mécanique (grinding) et gravure humide. La couche sacrificielle intermédiaire 131 sert également de couche d'arrêt à la gravure du substrat de report 130.

Ensuite, à l'étape 40, les différentes couches sacrificielles sont gravées, ici par gravure à l'acide fluorhydrique en phase valeur, et évacuées.

En particulier, on grave :
- la couche sacrificielle intermédiaire 131, formée à l'étape 34 ;
- la couche sacrificielle de capot 133, formée à l'étape 35 ;
- les première et seconde couches sacrificielles d'arrêt 121, 135, formées aux étapes 32, respectivement 36 ; et
- la couche sacrificielle de membrane 120, formée à l'étape 31.

Toutes ces couches sacrificielles sont gravées et évacuées, excepté, le cas échéant, des portions de la couche sacrificielle de membrane 120, situées entre des parois élémentaires des parois de soutien, et entre des parois ou piliers élémentaires des blocs de surélévation.

On grave en particulier la couche sacrificielle de capot, pour qu'il ne reste que le capot. En d'autres termes, on supprime les régions en matériau sacrificiel situées au-dessus des plots de connexion, et le matériau sacrificiel situé dans les ouvertures traversantes 1102.

Les portions de couches sacrificielles situées sous le capot 110 sont gravées et évacuées au travers des ouvertures 1102 formées dans le capot 110.

Ainsi, une même étape de gravure et évacuation de matériau sacrificiel permet à la fois de libérer l'espace sous le capot, au-dessus et en-dessous des membranes, et de libérer des régions au-dessus des plots de connexion.

Le procédé comprend ensuite des étapes classiques, non représentées, de mise sous vide, et dépôt d'une couche de bouchage sur le capot pour fermer les ouvertures traversantes 1102.

Un matériau getter, non représenté, peut être déposé sur la couche 134, avant l'étape 38 de report de substrat. Ce matériau getter doit être recouvert d'une couche de protection lors de la gravure des couches sacrificielles, la couche de protection pouvant ensuite être retirée.

Des étapes de texturation et/ou dépôt de couches de traitement (filtre optique, anti-reflet, etc.) peuvent être mises en œuvre sur le capot, avant l'étape 38 de report de substrat et/ou après l'étape 39 de retrait du substrat 130.

Bien que cet exemple ne soit pas limitatif, l'invention concerne de préférence un détecteur réalisé à l'aide de couches sacrificielles minérales gravées par vapeur d'acide fluorhydrique.

Selon l'invention, le capot est donc déposé non pas directement au-dessus des éléments sensibles, mais au-dessus d'un substrat de report. Par conséquent, une température de dépôt de la couche mince formant le capot n'est pas susceptible d'endommager ces éléments sensibles. Le choix des matériaux pouvant constituer le capteur n'est donc pas limité par une température de dépôt. En particulier, il n'est pas nécessaire de se limiter à des matériaux présentant une température de dépôt réduite, par exemple inférieure à 400°C voire même inférieure à 300°C.

Le capot selon l'invention est réalisé par dépôt de couche sur une surface plane. Ainsi, le choix de matériau(x) constituant le capot n'est pas non plus limité par une exigence de conformité relativement à une surface de dépôt non plane.

La figure 4 illustre une variante du procédé illustré aux figures 3A et 3B, dans laquelle, lors de l'étape de report du substrat 130 au-dessus des membranes 108, les premiers couche et plots de scellement 112A, 114A ne sont pas entourés de matériau sacrificiel et sont entourés par le milieu gazeux environnant.

De la même façon, lors de cette étape de report du substrat 130, les seconds couche et plots de scellement 112B, 114B ne sont pas entourés de matériau sacrificiel et sont entourés par le milieu gazeux environnant.

Dans ce cas, le collage entre les couches de scellement et entre les plots de scellement n'est pas un collage hybride, mais une hybridation classique par fusion ou thermocompression, utilisant des plots d'indium ou d'étain.

Il s'agit cependant toujours d'un collage sans chauffage à 300°C ou plus.

Cette variante, moins préférée, peut être avantageuse notamment lorsque la couche sacrificielle de membrane, et la couche sacrificielle de capot sont formées d'un matériau organique comme un polyimide, et gravées ensuite par plasma d'oxygène.

Selon une autre variante, non illustrée et ne faisant pas partie de l'invention, la couche sacrificielle de membrane est évacuée avant report du substrat 130.

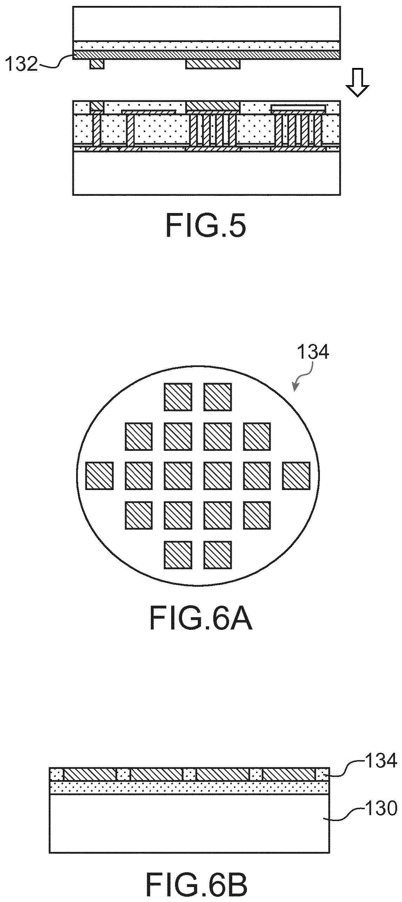

La figure 5 illustre une autre variante du procédé, dans laquelle, la couche de capot 132 n'est pas gravée avant l'étape de report du substrat 130, mais après retrait de ce substrat.

Enfin, les figures 6A et 6B illustrent de manière schématique la réalisation simultanée de plusieurs détecteurs selon l'invention.

La figure 6A illustre, selon une vue de dessus, une couche 134 comportant des régions en matériau sacrificiel et des régions de capot, délimitant ensemble une matrice de capots. Chaque zone hachurée correspond à un capot transparent.

La figure 6B illustre, selon une vue en coupe, un empilement comportant un substrat de report 130, une couche sacrificielle intermédiaire, et ladite couche 134.

On réalise ainsi plusieurs empilements de report tels que décrits ci-avant, partageant un même substrat de report, et déposés ensemble au-dessus de plusieurs empilements capteurs partageant un même substrat principal.

L'alignement entre le substrat principal et le substrat de report est réalisé une seule fois, pour fabriquer plusieurs détecteurs selon l'invention.

L'invention offre donc une solution astucieuse de packaging hermétique pour un détecteur de rayonnement électromagnétique à membrane(s) suspendue(s).

Il s'agit d'un packaging dit « wafer level », dans lequel, si le détecteur comporte plusieurs membranes, celles-ci sont encapsulées ensemble dans une même cavité hermétique.

L'invention est particulièrement avantageuse dans le cadre de membranes suspendues réalisées à l'aide d'une couche sacrificielle minérale libérée par gravure HF.

L'invention n'est pas limitée aux exemples décrits ici, et de nombreuses variantes peuvent être mises en œuvre sans sortir du cadre de l'invention.

Par exemple, le nombre de piliers de soutien sous le capot peut être ajusté en fonction de la rigidité du capot et de la hauteur de la cavité sous le capot.

Le détecteur selon l'invention peut ne pas présenter de piliers de soutien ni de premier et second plots de scellement, en particulier si la rigidité du capot est suffisante au regard de ses dimensions latérales.

Le détecteur 100 selon l'invention peut former un imageur infrarouge, un imageur thermique (thermographie), un capteur infrarouge (pouvant alors ne comporter qu'un unique pixel), un capteur téra-Hertz, un détecteur de gaz (par mesure d'une absorption optique dans le spectre infrarouge), un détecteur de personnes ou objets, un appareil de reconnaissance de personnes ou objets, un détecteur de mouvement dans le spectre infrarouge (par exemple pour réaliser une détection d'activité humaine), etc.

## Revendications

1. Détecteur (100) de rayonnement électromagnétique comportant :
- au moins une membrane (108) suspendue au-dessus d'un substrat (101), configurée pour absorber et convertir en chaleur un rayonnement électromagnétique incident ; et
- un capot (110), transparent dans une plage de sensibilité spectrale du détecteur de rayonnement électromagnétique, et fermant une cavité hermétique (115) recevant l'au moins une membrane ;
**caractérisé en ce que** :
- le capot (110) présente une épaisseur (E) inférieure ou égale à 10 µm ;
- le capot est suspendu au-dessus du substrat, en appui au moins sur des parois de soutien (106) encadrant la ou les membrane(s) ;
- le détecteur (100) présente des première et des seconde couches de scellement (112A, 112B), métalliques, intercalées l'une sur l'autre entre le capot et les parois de soutien, et entre lesquelles s'étend une zone périphérique de collage (112C)
- le capot (110) présente une ou plusieurs ouverture(s) traversante(s) (1102) et une couche de bouchage (111) transparente recouvre le capot de façon à participer à l'herméticité de la cavité hermétique (115)
- les première et seconde couches de scellement (112A, 112B) participent à l'herméticité de la cavité hermétique (115).

2. Détecteur (100) selon la revendication 1 dans lequel les parois de soutien (106) présentent un plateau supérieur (1064), la première couche de scellement (112A) s'étend en contact physique direct avec une face supérieure du plateau supérieur (1064) des parois de soutien (106) et l'épaisseur cumulée des première et des seconde couches de scellement (112A, 112B) est sensiblement égale à une distance entre la membrane (108) et le capot (110).

3. Détecteur (100) selon la revendication 1 ou 2, **caractérisé en ce que** :
- le capot (110) est suspendu au-dessus du substrat, en appui sur les parois de soutien (106), et sur des piliers de soutien (104) situés entre les parois de soutien ; et
- le détecteur comprend des paires de premier et second plots de scellement (114A, 114B), métalliques, chaque paire étant située entre le capot et l'un des piliers de soutien (104), les premier et second plots de scellement de chaque paire étant superposés et séparés par une zone interne de collage respective (114C).

4. Détecteur (100) selon la revendication 3, **caractérisé en ce qu'**il présente une pluralité de membranes (108) suspendues au-dessus du substrat, un pas (P) de répartition des membranes étant égal à un pas de répartition des piliers de soutien (104), dans chaque dimension du plan du substrat.

5. Détecteur (100) selon les revendications 3 ou 4, **caractérisé en ce que** la ou les membrane(s) (108) sont suspendue(s) au-dessus du substrat, en appui chacune sur des piliers d'appui (105), et **en ce que** pour chaque membrane, l'un des piliers d'appui est surmonté par une paire de premier et second plots de scellement (114A, 114B), de sorte que ledit pilier d'appui forme également un pilier de soutien (104) pour le capot.

6. Détecteur (100) selon au moins une des revendications 1 à 5, **caractérisé en ce que** la ou les membrane(s) (108) sont suspendue(s) au-dessus du substrat, en appui chacune sur des piliers d'appui (105), et **en ce que** pour chaque membrane, l'un des piliers d'appui (105) est surmonté d'une ouverture traversante (1102) du capot.

7. Détecteur (100) selon l'une quelconque des revendications 1 à 6, **caractérisé en ce qu'**une épaisseur cumulée des première et des seconde couches de scellement (112A, 112B) est comprise entre 1,5 µm et 2,5 µm.

8. Procédé d'encapsulation d'au moins un élément sensible d'un détecteur (100) de rayonnement électromagnétique, **caractérisé en ce qu'**il comporte les étapes suivantes :
a) réalisation d'un empilement, dit empilement capteur (117), comportant :
- un premier substrat (101), dit substrat principal ;
- au moins une membrane (108) s'étendant au-dessus du substrat principal, formant l'au moins un élément sensible du détecteur de rayonnement électromagnétique, et configurée pour absorber et convertir en chaleur un rayonnement électromagnétique incident, l'au moins une membrane s'étendant en outre au-dessus d'une couche en matériau sacrificiel, dite couche sacrificielle de membrane ;
- des parois de soutien (106), s'étendant au-dessus du substrat principal et encadrant l'au moins une membrane ; et
- une première couche de scellement (112A), métallique, située au-dessus des faces supérieures des parois de soutien, du côté opposé au substrat principal;
b) dépôt, au-dessus d'un second substrat (130) dit substrat de report, d'une couche dite couche de capot (132), transparente dans une plage de sensibilité spectrale du détecteur de rayonnement électromagnétique, et d'épaisseur inférieure ou égale à 10 µm ;
c) réalisation, sur la couche de capot, d'une seconde couche de scellement (112B), métallique ;
d) report du substrat de report (130) sur le substrat principal (101), de façon à aligner et coller l'une sur l'autre, la première couche de scellement (112A) et la seconde couche de scellement (112B) ; et
e) retrait du substrat de report (130),
le procédé comprenant en outre une étape de :
- gravure de la couche de capot (132), pour délimiter le contour externe d'un capot (110) destiné à fermer une cavité recevant l'au moins une membrane, et pour former dans ce capot au moins une ouverture traversante (1102),
le procédé comportant ultérieurement une étape de :
- évacuation de la couche sacrificielle de membrane après le retrait du substrat de report (130),
- dépôt d'une couche de bouchage transparente sur le capot pour fermer l'au moins une ouverture traversante, la couche de bouchage étant configurée pour participer à l'herméticité de la cavité hermétique (115).

9. Procédé selon la revendication 8, **caractérisé en ce que** :
- l'empilement capteur (117) comporte en outre des piliers de soutien (104), s'étendant entre les parois de soutien, et surmontés chacun par un premier plot de scellement respectif (114A) ;
- l'étape c) comprend également la réalisation, sur la couche de capot, de seconds plots de scellement (114B) ; et
- l'étape d) réalise également l'alignement et le collage deux à deux, des premiers plots de scellement (114A) avec les seconds plots de scellement (114B).

10. Procédé selon la revendication 8 ou 9, **caractérisé en ce que** l'étape de gravure de la couche de capot est mise en œuvre après l'étape e) de retrait du substrat de report.

11. Procédé selon la revendication 8, 9 ou 10, **caractérisé en ce que** :
- l'étape de gravure de la couche de capot est mise en œuvre après l'étape b) de dépôt de la couche de capot (132) et avant l'étape d) de report du substrat de report (130) ;
- l'étape de gravure de la couche de capot est suivie d'une étape de remplissage des régions gravées par une couche en matériau sacrificiel, dite couche sacrificielle de capot (133) ; et
- la couche sacrificielle de capot (133) est évacuée après l'étape e) de retrait du substrat de report.

12. Procédé selon l'une quelconque des revendications 8 à 11, **caractérisé en ce que** :
- le procédé comprend des étapes de dépôt de couches en matériau sacrificiel, dites couches sacrificielles d'arrêt (121, 135), de sorte qu'avant l'étape d) de report du substrat de report, la première couche de scellement (112A) et la deuxième couche de scellement (112B) soient situées chacune dans l'une de ces couches sacrificielles d'arrêt ;
- l'étape d) met en œuvre un collage hybride ; et
- les couches sacrificielles d'arrêt (121, 135) sont évacuées après l'étape e) de retrait du substrat de report.

13. Procédé selon l'une quelconque des revendications 8 à 12, **caractérisé en ce que** dans l'empilement capteur (117), à l'issue de l'étape a), l'au moins une membrane (108) s'étend au-dessus d'une couche en matériau sacrificiel, dite couche sacrificielle de membrane (120), la couche sacrificielle de membrane étant évacuée après l'étape e) de retrait du substrat de report.

14. Procédé selon l'une quelconque des revendications 8 à 13, **caractérisé en ce qu'**il est mis en œuvre simultanément pour plusieurs empilements capteur (117) partageant le même substrat principal (101), et à l'aide d'un unique substrat de report (130) et d'une unique couche de capot (132), une étape de gravure de la couche de capot délimitant les contours externes de plusieurs capots (110) destinés chacun à recouvrir l'un parmi les plusieurs empilements capteur.

## Patentansprüche

1. Detektor (100) für elektromagnetische Strahlung, umfassend:
- mindestens eine Membran (108), die über einem Substrat (101) aufgehängt ist, die so eingerichtet ist, dass sie eine einfallende elektromagnetische Strahlung absorbiert und in Wärme umwandelt; und
- eine Abdeckung (110), die in einem spektralen Empfindlichkeitsbereich des Detektors für elektromagnetische Strahlung transparent ist und einen hermetischen Hohlraum (115) verschließt, der die mindestens eine Membran aufnimmt;
**dadurch gekennzeichnet, dass**:
- die Abdeckung (110) eine Dicke (E) von 10 µm oder weniger aufweist;
- die Abdeckung über dem Substrat aufgehängt ist und mindestens auf Stützwänden (106) aufliegt, die die Membran(en) umgeben;
- der Detektor (100) eine erste und eine zweite metallische Dichtungsschicht (112A, 112B) aufweist, die zwischen der Abdeckung und den Stützwänden übereinander angeordnet sind und zwischen denen sich ein Kleberandbereich (112C) erstreckt
- die Abdeckung (110) eine oder mehrere Durchgangsöffnungen (1102) aufweist und eine transparente Verschlussschicht (111) die Abdeckung bedeckt, um an der Abdichtung des hermetischen Hohlraumes (115) teilzunehmen
- die erste und zweite Dichtungsschicht (112A, 112B) an der Abdichtung des hermetischen Hohlraums (115) teilnehmen.

2. Detektor (100) nach Anspruch 1, wobei die Stützwände (106) eine obere Platte (1064) aufweisen, sich die erste Dichtungsschicht (112A) in direktem physikalischen Kontakt mit einer Oberseite der oberen Platte (1064) der Stützwände (106) erstreckt und die kumulative Dicke der ersten und zweiten Dichtungsschichten (112A, 112B) im Wesentlichen gleich einem Abstand zwischen der Membran (108) und der Abdeckung (110) ist.

3. Detektor (100) nach Anspruch 1 oder 2, **dadurch gekennzeichnet, dass**:
- die Abdeckung (110) über dem Substrat aufgehängt ist, auf den Stützwänden (106) aufliegt, und auf Stützpfosten (104) aufliegt, die sich zwischen den Stützwänden befinden; und
- der Detektor Paare erster und zweiter Dichtungsklötze (114A, 114B) aus Metall umfasst, wobei sich jedes Paar zwischen der Abdeckung und einem der Stützpfosten (104) befindet, wobei die ersten und zweiten Dichtungsklötze jedes Paares übereinander liegen und durch einen jeweiligen inneren Klebebereich (114C) getrennt sind.

4. Detektor (100) nach Anspruch 3, **dadurch gekennzeichnet, dass** er eine Vielzahl von Membranen (108) aufweist, die über dem Substrat aufgehängt sind, wobei ein Verteilungsschritt (P) der Membranen in jeder Dimension der Substratebene gleich einem Verteilungsschritt der Stützpfosten (104) ist.

5. Detektor (100) nach Anspruch 3 oder 4, **dadurch gekennzeichnet, dass** die Membran(en) (108) über dem Substrat aufgehängt sind und jede davon auf Stützpfosten (105) aufliegt, und dass für jede Membran einer der Stützpfosten von einem Paar erster und zweiter Dichtungsklötze (114A, 114B) überragt wird, so dass der Stützpfosten auch einen Stützpfosten (104) für die Abdeckung bildet.

6. Detektor (100) nach mindestens einem der Ansprüche 1 bis 5, **dadurch gekennzeichnet, dass** die Membran(en) (108) über dem Substrat aufgehängt sind und jede davon auf Stützpfosten (105) aufliegt, und dass für jede Membran einer der Stützpfosten (105) von einer Durchgangsöffnung (1102) der Abdeckung überragt wird.

7. Detektor (100) nach einem der Ansprüche 1 bis 6, **dadurch gekennzeichnet, dass** eine kumulative Dicke der ersten und der zweiten Dichtungsschicht (112A, 112B) zwischen 1,5 µm und 2,5 µm liegt.

8. Verfahren zum Einkapseln mindestens eines empfindlichen Elements eines Detektors (100) für elektromagnetische Strahlung, **dadurch gekennzeichnet, dass** es folgende Schritte umfasst:
a) Herstellen eines Stapels, der als Sensorstapel (117) bezeichnet wird, umfassend:
- ein erstes Substrat (101), das als Hauptsubstrat bezeichnet wird;
- mindestens eine Membran (108), die sich über das Hauptsubstrat erstreckt, das mindestens ein empfindliches Element des Detektors für elektromagnetische Strahlung bildet und so eingerichtet ist, dass sie eine einfallende elektromagnetische Strahlung absorbiert und in Wärme umwandelt, wobei sich die mindestens eine Membran weiter über eine Schicht aus Opfermaterial, die als Membranopferschicht bezeichnet wird, erstreckt;
- Stützwände (106), die sich über das Hauptsubstrat erstrecken und die mindestens eine Membran umgeben; und
- eine erste metallische Dichtungsschicht (112A), die sich oberhalb der Oberseiten der Stützwände auf der dem Hauptsubstrat gegenüberliegenden Seite befindet;
b) Ablagern, über einem zweiten Substrat (130), das als Übertragungssubstrat bezeichnet wird, einer Schicht, die als Abdeckungsschicht (132) bezeichnet wird, die in einem spektralen Empfindlichkeitsbereich des Detektors für elektromagnetische Strahlung transparent ist und eine Dicke von 10 µm oder weniger hat;
c) Herstellen einer zweiten metallischen Dichtungsschicht (112B) auf der Abdeckungsschicht;
d) Übertragen des Übertragungssubstrats (130) auf das Hauptsubstrat (101), so dass die erste Dichtungsschicht (112A) und die zweite Dichtungsschicht (112B) ausgerichtet und aufeinander geklebt werden; und
e) Entfernen des Übertragungssubstrats (130),
das Verfahren weiter umfassend folgenden Schritt:
- Ätzen der Abdeckungsschicht (132), um die Außenkontur einer Abdeckung (110) zu begrenzen, die dazu bestimmt ist, einen Hohlraum zu verschließen, der die mindestens eine Membran aufnimmt, und um in dieser Abdeckung mindestens eine Durchgangsöffnung (1102) zu bilden,
wobei das Verfahren anschließend folgenden Schritt umfasst:
- Abführen der Membranopferschicht nach dem Entfernen des Übertragungssubstrats (130),
- Ablagern einer transparenten Verschlussschicht auf die Abdeckung, um die mindestens eine Durchgangsöffnung zu verschließen, wobei die Verschlussschicht so eingerichtet ist, dass sie an der Dichtheit des hermetischen Hohlraumes (115) teilnimmt.

9. Verfahren nach Anspruch 8, **dadurch gekennzeichnet, dass**:
- der Sensorstapel (117) weiter Stützpfosten (104) umfasst, die sich zwischen den Stützwänden erstrecken und jeweils von einem jeweiligen ersten Dichtungsklotz (114A) überragt werden;
- Schritt c) auch das Herstellen, auf der Abdeckungsschicht, von zweiten Dichtungsklötzen (114B) umfasst; und
- Schritt d) auch das Ausrichten und das paarweise Verkleben der ersten Dichtungsklötze (114A) mit den zweiten Dichtungsklötzen (114B) durchführt.

10. Verfahren nach Anspruch 8 oder 9, **dadurch gekennzeichnet, dass** der Schritt des Ätzens der Abdeckungsschicht nach dem Schritt e) des Entfernens des Übertragungssubstrats durchgeführt wird.

11. Verfahren nach Anspruch 8, 9 oder 10, **dadurch gekennzeichnet, dass**:
- der Schritt des Ätzens der Abdeckungsschicht nach dem Schritt b) des Ablagerns der Abdeckungsschicht (132) und vor dem Schritt d) des Übertragens des Übertragungssubstrats (130) durchgeführt wird;
- dem Schritt des Ätzens der Abdeckungsschicht ein Schritt des Füllens der geätzten Bereiche mit einer Schicht aus Opfermaterial, die als Abdeckungsopferschicht (133) bezeichnet wird, folgt; und
- die Abdeckungsopferschicht (133) nach dem Schritt e) des Entfernens des Übertragungssubstrats abgeführt wird.

12. Verfahren nach einem der Ansprüche 8 bis 11, **dadurch gekennzeichnet, dass**:
- das Verfahren Schritte des Ablagerns von Schichten aus Opfermaterial, die als Opferschichten (121, 135) bezeichnet werden, umfasst, so dass sich vor dem Schritt d) des Übertragens des Übertragungssubstrats die erste Dichtungsschicht (112A) und die zweite Dichtungsschicht (112B) jeweils in einer dieser Opferschichten befinden;
- Schritt d) eine Hybridverklebung umsetzt; und
- die Opferschichten (121, 135) nach dem Schritt e) des Entfernens des Übertragungssubstrats abgeführt werden.

13. Verfahren nach einem der Ansprüche 8 bis 12, **dadurch gekennzeichnet, dass** sich in dem Sensorstapel (117), nach Abschluss des Schritts a), die mindestens eine Membran (108) über eine Schicht aus Opfermaterial, die als Membranopferschicht (120) bezeichnet wird, erstreckt, wobei die Membranopferschicht nach dem Schritt e) des Entfernens des Übertragungssubstrats abgeführt wird.

14. Verfahren nach einem der Ansprüche 8 bis 13, **dadurch gekennzeichnet, dass** es gleichzeitig für mehrere Sensorstapel (117), die sich das gleiche Hauptsubstrat (101) teilen, und unter Verwendung eines einzigen Übertragungssubstrats (130) und einer einzigen Abdeckungsschicht (132) einen Schritt des Ätzens der Abdeckungsschicht durchführt, der die Außenkonturen mehrerer Abdeckungen (110) begrenzt, die jeweils dazu bestimmt sind, einen der mehreren Sensorstapel zu bedecken.

## Claims

1. A thermal electromagnetic radiation detector (100), comprising:
- at least one membrane (108) suspended above a substrate (101), configured to absorb incident electromagnetic radiation and convert it into heat; and
- a cover (110), transparent in a spectral sensitivity range of the electromagnetic radiation detector, and closing a hermetic cavity (115) receiving the at least one membrane;
**characterised in that**:
- the cover (110) has a thickness (E) less than or equal to 10 µm;
- the cover is suspended above the substrate, resting at least on support walls (106) surrounding the membrane(s);
- the detector (100) has first and second metallic sealing layers (112A, 112B), interposed on each other between the cover and the support walls, and between which a peripheral bonding zone (112C) extends
- the cover (110) has one or more through opening(s) (1102) and a transparent filling layer (111) covers the cover so as to contribute to the hermeticity of the hermetic cavity (115)
- the first and second sealing layers (112A, 112B) contribute to the hermeticity of the hermetic cavity (115).

2. The detector (100) according to claim 1 wherein the support walls (106) have an upper plate (1064), the first sealing layer (112A) extends in direct physical contact with an upper face of the upper plate (1064) of the support walls (106) and the cumulative thickness of the first and second sealing layers (112A, 112B) is substantially equal to a distance between the membrane (108) and the cover (110).

3. The detector (100) according to claim 1 or 2, **characterised in that**
- the cover (110) is suspended above the substrate, resting on the support walls (106), and on support pillars (104) located between the support walls; and
- the detector comprises pairs of first and second metallic sealing pads (114A, 114B), each pair being located between the cover and one of the support pillars (104), the first and second sealing pads of each pair being superposed and separated by a respective internal bonding zone (114C).

4. The detector (100) according to claim 3, **characterised in that** it has a plurality of membranes (108) suspended above the substrate, a distribution pitch (P) of the membranes being equal to a distribution pitch of the support pillars (104), in each dimension of the substrate plane.

5. The detector (100) according to claims 3 or 4, **characterised in that** the membrane(s) (108) are suspended above the substrate, each resting on support pillars (105), and **in that** for each membrane, one of the support pillars is topped by a pair of first and second sealing pads (114A, 114B), such that said support pillar also forms a support pillar (104) for the cover.

6. The detector (100) according to at least one of claims 1 to 5, **characterised in that** the membrane(s) (108) are suspended above the substrate, each resting on support pillars (105), and **in that** for each membrane, one of the support pillars (105) is topped by a through opening (1102) of the cover.

7. The detector (100) according to any one of claims 1 to 6, **characterised in that** a cumulative thickness of the first and second sealing layers (112A, 112B) is between 1.5 µm and 2.5 µm.

8. A method for encapsulating at least one sensitive element of an electromagnetic radiation detector (100), **characterised in that** it comprises the following steps:
a) producing a stack, referred to as sensor stack (117), comprising:
- a first substrate (101), referred to as main substrate;
- at least one membrane (108) extending above the main substrate, forming the at least one sensitive element of the electromagnetic radiation detector, and configured to absorb incident electromagnetic radiation and convert it into heat, the at least one membrane furthermore extending above a layer of sacrificial material, referred to as sacrificial membrane layer;
- support walls (106), extending above the main substrate and surrounding the at least one membrane; and
- a first metallic sealing layer (112A), located above the upper faces of the support walls, on the side opposite the main substrate;
b) depositing, above a second substrate (130) referred to as transfer substrate, a layer referred to as cover layer (132), transparent in a spectral sensitivity range of the electromagnetic radiation detector, and with a thickness less than or equal to 10 µm;
c) producing, on the cover layer, a second metallic sealing layer (112B);
d) transferring the transfer substrate (130) onto the main substrate (101), so as to align and bond together the first sealing layer (112A) and the second sealing layer (112B); and
e) removing the transfer substrate (130),
the method further comprising a step of:
- etching the cover layer (132), to delimit the outer contour of a cover (110) intended to close a cavity receiving the at least one membrane, and to form at least one through opening (1102) in this cover,
the method subsequently comprising a step of:
- removing the sacrificial membrane layer after removing the transfer substrate (130),
- depositing a transparent filling layer on the cover to close the at least one through opening, the filling layer being configured to contribute to the tightness of the hermetic cavity (115).

9. The method according to claim 8, **characterised in that**
- the sensor stack (117) further comprises support pillars (104), extending between the support walls, and each topped by a respective first sealing pad (114A);
- step c) also comprises producing, on the cover layer, second sealing pads (114B); and
- step d) also carries out alignment and bonding in pairs, of the first sealing pads (114A) with the second sealing pads (114B).

10. The method according to claim 8 or 9, **characterised in that** the step of etching the cover layer is implemented after the step e) of removing the transfer substrate.

11. The method according to claim 8, 9 or 10, **characterised in that**:
- the step of etching the cover layer is implemented after the step b) of depositing the cover layer (132) and before the step d) of transferring the transfer substrate (130);
- the step of etching the cover layer is followed by a step of filling the etched regions with a layer of sacrificial material, referred to as sacrificial cover layer (133); and
- the sacrificial cover layer (133) is removed after step e) of removing the transfer substrate.

12. The method according to any one of claims 8 to 11, **characterised in that**:
- the method comprises steps of depositing layers of sacrificial material, referred to as sacrificial stop layers (121, 135), so that before step d) of transferring the transfer substrate, the first sealing layer (112A) and the second sealing layer (112B) are each located in one of these sacrificial stop layers;
- step d) implements hybrid bonding; and
- the sacrificial stop layers (121, 135) are removed after step e) of removing the transfer substrate.

13. The method according to any one of claims 8 to 12, **characterised in that** in the sensor stack (117), at the end of step a), the at least one membrane (108) extends above a layer of sacrificial material, referred to as sacrificial membrane layer (120), the sacrificial membrane layer being removed after step e) of removing the transfer substrate.

14. The method according to any one of claims 8 to 13, **characterised in that** it is implemented simultaneously for several sensor stacks (117) sharing the same main substrate (101), and using a single transfer substrate (130) and a single cover layer (132), a step of etching the cover layer delimiting the outer contours of several covers (110) each intended to cover one of the several sensor stacks.
